(19) Europäisches Patentamt
European Patent Office
Office européen des brevets

(11) **EP 4 459 301 B1**

(12) # EUROPEAN PATENT SPECIFICATION

(45) Date of publication and mention
of the grant of the patent:
**18.02.2026  Bulletin 2026/08**

(21) Application number: **23882832.1**

(22) Date of filing: **20.07.2023**

(51) International Patent Classification (IPC):
**G01R 31/392** (2019.01)     **G01R 31/389** (2019.01)
**G01R 23/02** (2006.01)

(52) Cooperative Patent Classification (CPC):
**G01R 31/392; B60L 3/0046; B60L 3/12;
B60L 58/16; G01R 31/389; H01M 10/42;**
G01R 31/396; H01M 10/4285; Y02E 60/10

(86) International application number:
**PCT/KR2023/010458**

(87) International publication number:
**WO 2024/090724 (02.05.2024 Gazette 2024/18)**

(54) **HIGH-SPEED BATTERY DEFECT INSPECTION METHOD**

VERFAHREN ZUR HOCHGESCHWINDIGKEITS-FEHLERÜBERPRÜFUNG EINER BATTERIE

PROCÉDÉ D'INSPECTION DE DÉFAUT DE BATTERIE À GRANDE VITESSE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **28.10.2022  KR 20220140870**

(43) Date of publication of application:
**06.11.2024  Bulletin 2024/45**

(73) Proprietor: **LG Energy Solution, Ltd.
Seoul 07335 (KR)**

(72) Inventors:
• **HEO, Yeonhyuk
Daejeon 34122 (KR)**
• **LEE, Eun Ju
Daejeon 34122 (KR)**
• **SON, Kihyun
Daejeon 34122 (KR)**
• **SHIN, Du Hyeon
Daejeon 34122 (KR)**
• **HWANG, Gyo Hyun
Daejeon 34122 (KR)**
• **KIM, Hyuk
Daejeon 34122 (KR)**
• **RAH, Kyun Il
Daejeon 34122 (KR)**

(74) Representative: **Goddar, Heinz J.
Boehmert & Boehmert
Anwaltspartnerschaft mbB
Pettenkoferstrasse 22
80336 München (DE)**

(56) References cited:
CN-A- 103 884 995      CN-A- 104 914 312
CN-A- 111 537 904      JP-A- 2007 333 494
KR-A- 20140 080 342    KR-A- 20220 039 452
KR-A- 20220 039 452    KR-A- 20220 093 842
US-B2- 11 264 599

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

The present application claims the benefit of priority based on Korean Patent Application No. 10-2022-0140870 filed on October 28, 2022.

The present disclosure relates to high-speed battery defect inspection methods and more particularly, to high-speed battery defect inspection methods for determining a battery defect in a short time by predicting deterioration characteristics of a battery formed by stacking a plurality of monocells.

Background Art

In the case of a medium or large-sized battery in which a plurality of monocells are stacked, there is a problem in that some monocells inside exhibit a low-voltage defect phenomenon (a phenomenon in which the potential of a specific monocell decreases) for which the cause is unknown, and a defect phenomenon in which the capacity of all cells degrades.

Products, such as ESSs and vehicle batteries equipped with low-voltage defective cells which are shipped, exhibit significant instability in performance over a long period of time and may reduce product reliability. The document US 11 264 599 B2 discloses a method of determining a battery condition involving the application an AC signal to the battery at various frequencies wherein the resulting impedance measurements are used to determine the battery condition

Conventionally, battery voltage tracking is performed to detect low-voltage defective batteries in a battery shipping stage. In the case of battery voltage tracking, it generally took a long time of 2 weeks or more. In addition, there is a high pressure current detection (HPCD) inspection method that considers the main cause of the low-voltage defect as the folding phenomenon of the separator, but there is a limit to detecting by the HPCD inspection method.

Therefore, there is a need for an inspection method capable of detecting low-voltage defective cells with existing inspection methods and simultaneously inspecting all of the cells in a short time.

Disclosure of the Invention

Technical Goals

The present disclosure relates to high-speed battery defect inspection methods, and more particularly, provides high-speed battery defect inspection methods by predicting deterioration characteristics of a battery formed by stacking a plurality of monocells and determining a battery defect in a short time.

Technical objects to be achieved by the present disclosure are not limited to the technical objects mentioned above, and other technical objects not mentioned will be clearly understood by those skilled in the art from the description below.

Technical Solutions

A high-speed battery defect inspection method of the present disclosure includes

an analysis target impedance measurement step (s30) of obtaining an analysis target impedance which is an impedance of an analysis target battery by applying alternating current of a set frequency to the analysis target battery;

a real part resistance extraction step (s40) of extracting a real part value as a real part resistance from the analysis target impedance; and

a defect determination step (s50) of determining a low-voltage defect of the analysis target battery based on the real part resistance,

wherein the set frequency is selected from frequencies when an imaginary part resistance which is an imaginary part value of the analysis target impedance is greater than 0.

Advantageous Effects

A high-speed battery defect inspection method of the present disclosure may detect low-voltage defective batteries in a short time, and may be capable of inspecting thousands to tens of thousands of batteries per second.

The high-speed battery defect inspection method of the present disclosure is capable of performing non-destructive inspection on finished batteries, and may be applicable to batteries in mass production lines and batteries that have already been produced.

Compared to conventional methods, the high-speed battery defect inspection method of the present disclosure significantly reduces inspection time, and may be capable of determining defects even in batteries that have not been inspected.

Brief Description of Drawings

FIG. 1 is a block diagram illustrating a high-speed battery defect inspection method of the present disclosure.

FIG. 2 is a graph illustrating a general Nyquist diagram.

FIG. 3 is a graph comparing impedance values of a normal battery and a defective battery.

FIG. 4 is a block diagram illustrating another embodiment of a high-speed battery defect inspection method of the present disclosure.

FIG. 5 is a block diagram illustrating a set frequency step.

Best Mode for Carrying Out the Invention

A high-speed battery defect inspection method of the present disclosure may include

an analysis target impedance measurement step (s30) of obtaining an analysis target impedance which is impedance of an analysis target battery measured by applying an alternating current at a set frequency to the analysis target battery;
a real part resistance extraction step (s40) of extracting a real part value as a real part resistance from the analysis target impedance; and
a defect determination step (s50) of determining a defect of the analysis target battery based on the real part resistance,
wherein the set frequency is selected from frequencies in which an imaginary part value of the analysis target impedance is greater than 0.

In the high-speed battery defect inspection method of the present disclosure, the set frequency may be from $10^{-2}$ kHz to 7 MHz.

In the high-speed battery defect inspection method of the present disclosure, the analysis target battery may include a plurality of monocells.

The high-speed battery defect inspection method of the present disclosure may further include

prior to the analysis target impedance measurement step (s30),
a reference impedance measurement step (s10) of obtaining a plurality of reference impedances for a plurality of frequencies by applying an alternating current to a reference battery at varying frequencies; and
a set frequency calculation step (s20) of calculating the set frequency based on the plurality of reference impedances.

In the high-speed battery defect inspection method of the present disclosure, the reference battery may have a dOCV of 300 mV or greater or three sigma or more.

In the high-speed battery defect inspection method of the present disclosure, the set frequency calculation step (s20) may include a variable separation step (s21) of separating the plurality of reference impedances into real part values $Z_{SR}$ and imaginary part values $Z_{S1}$, a function fitting step (s22) of fitting a function f to relate the $Z_{SR}$ to the $Z_{S1}$, and a set frequency acquisition step (s23) of obtaining the set frequency based on the function.

In the function fitting step (s22) of the high-speed battery defect inspection method of the present disclosure, the function f may be fitted by an equation of Formula 1 below.

[Formula 1]

$$Z_{SR} = f(Z_{SI})$$

In the set frequency acquisition step (s23) of the high-speed battery defect inspection method of the present disclosure, the set frequency may be selected from frequencies satisfying an equation of Formula 2 below for a section in which $Z_{SI}$ has a value greater than 0.

[Formula 2]

$$-\varepsilon \le \frac{df(Z_{SI})}{dZ_{SI}} \le \varepsilon$$

wherein $\varepsilon$ is from 0.0 to 0.2.

In the set frequency acquisition step of the high-speed battery defect inspection method of the present disclosure, $\varepsilon$ may be 0.

In the defect determination step (s50) of the high-speed battery defect inspection method of the present disclosure, the analysis target battery may be determined as a defective battery when the real part resistance is at least 30% greater than the $Z_{SI}$ value satisfying the equation of Formula 2.

A battery activation method of the present disclosure may include

an activation battery preparation step of assembling an activation target battery;
a charging/discharging step of charging or discharging the activation target battery;
a stabilization step of stabilizing the activation target battery by storing the activation target battery for a predetermined period of time at a set temperature and a set humidity; and
a defect screening step of finally screening defective batteries by performing the high-speed battery defect inspection method using the activation target battery as the analysis target battery.

The battery activation method of the present disclosure may further include

between the activation battery preparation step and the charging/discharging step,
a pre-inspection step of pre-inspecting the activation target battery by performing the high-speed battery defect inspection method using the activation target battery as the analysis target battery.

Modes for Carrying Out the Invention

Hereinafter, embodiments according to the present disclosure will be described in detail with reference to the accompanying drawings. In this process, the size or shape of the components shown in the drawings may be exaggerated for clarity and convenience of explanation. In addition, terms specifically defined in consideration of the configuration and operation of the present disclosure may vary according to the intentions or customs of users and operators. Definitions of these terms should be made based on the content throughout this specification.

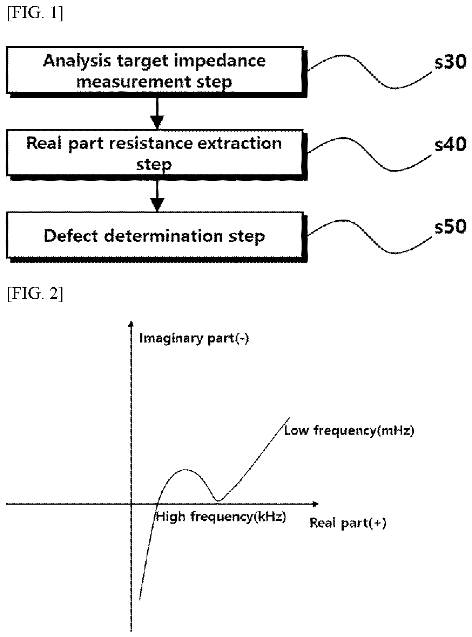

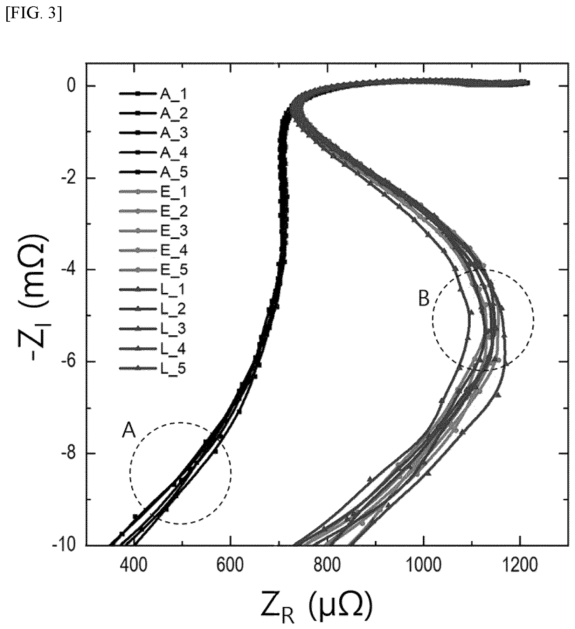

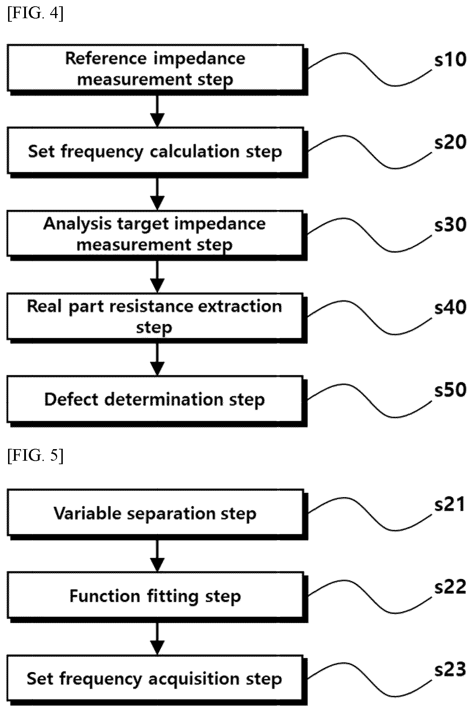

FIG. 1 is a block diagram illustrating a high-speed battery defect inspection method of the present disclosure. FIG. 2 is a graph illustrating a general Nyquist diagram. FIG. 3 is a graph comparing impedance values of a normal battery and a defective battery. FIG. 4 is a block diagram illustrating another embodiment of a high-speed battery defect inspection method of the present disclosure. FIG. 5 is a block diagram illustrating a set frequency step.

Hereinafter, with reference to FIGS. 1 to 5, high-speed battery defect inspection methods of the present disclosure will be described in detail.

As shown in FIG. 1, a high-speed battery defect inspection method of the present disclosure may include

an analysis target impedance measurement step (s30) of obtaining an analysis target impedance which is an impedance of an analysis target battery by applying an alternating current at a set frequency to the analysis target battery;
a real part resistance extraction step (s40) of extracting a real part value as a real part resistance from the analysis target impedance; and
a defect determination step (s50) of determining a defect of the analysis target battery based on the real part resistance,
wherein the set frequency is selected from frequencies in which an imaginary part value of the analysis target impedance is greater than 0.

In the high-speed battery defect inspection methods of the present disclosure, the analysis target battery may include a plurality of monocells.

The monocell may be a unit cell having different types of electrodes located on both sides of the outermost surface when one or more cathodes and one or more anodes are stacked with a separator therebetween to form an electrode assembly. For example, a monocell may be a unit cell having an electrode assembly having a structure in which a cathode-separator-anode are stacked in that order. For another example, the monocell may be a unit cell having an electrode assembly having a structure in which a cathode-separator-anode-separator-cathode-separator-anode are stacked in that order.

The cathode may be a cathode current collector coated with a cathode active material.

The anode may be an anode current collector coated with an anode active material.

The separator may be an insulator through which ions pass.

**In** the analysis target impedance measurement step (s30), the set frequency may be $10^{-2}$ kHz to 7 MHz. **In** the case of a low-voltage defective battery, it has an impedance value different from that of a normal battery at a high frequency, and in particular, shows a difference in a real component among impedance values.

When impedance spectroscopy (EIS) is performed on the battery, a graph on the complex plane as shown in FIG. 2 may be obtained. Specifically, in the impedance value corresponding to each frequency, a value obtained by multiplying an imaginary part by (-) and a value of the real part may be displayed as coordinates to obtain a Nyquist diagram as shown in FIG. 2. The high-speed battery defect inspection method of the present disclosure may be capable of high-speed discriminating low-voltage defects of a battery based on real part values in the second quadrant of the graph of FIG. 2.

FIG. 3 is a graph illustrating impedance spectroscopy measurement results for 15 batteries. In FIG. 3, five graphs of A_1, A_2, A_3, A_4 and A_5 are graphs for normal batteries, five graphs E_1, E_2, E_3, E_4, and E_5 are graphs for grade E defective batteries, and five graphs L_1, L_2, L_3, L_4, and L_5 are graphs for grade L defective batteries. The grade E defective battery may be a defective battery that exhibits absolute OCV decrease. The grade L defective battery may be a defective battery that exhibits relative OCV decrease. In FIG. 3, it can be seen that the graphs of EIS measured values of low-voltage defective batteries (grade E defective batteries and grade L defective batteries) overlap each other regardless of the defect grade, but the graphs of normal batteries exhibit different behaviors from those of defective batteries. Specifically, at the measured impedance value of about 10 kHz, normal batteries appear in area A, and grade E defective batteries and grade L defective batteries appear in area B. In the case of grade E defective batteries and grade L defective batteries, it can be seen that they have a maximum value for the real part value in area B. Therefore, in the analysis target impedance measurement step (s30), the set frequency may be a frequency selected from $10^{-2}$ kHz to 7 MHz. More preferably, the set frequency may be a frequency selected from $10^{-1}$ kHz to $10^{2}$ kHz. **In** the frequency range of $10^{-2}$ kHz to 7 MHz, the low-voltage defective battery has an abnormal increase in the real part resistance value, and using this, it is possible to determine whether the battery is a low-voltage defective battery.

As shown in FIG. 4, high-speed battery defect inspection methods of the present disclosure may further include prior to the analysis target impedance measurement step (s30),
a reference impedance measurement step (s10) of obtaining a plurality of reference impedances for a plurality of frequencies by applying an alternating current to a reference battery at varying frequencies; and
a set frequency calculation step (s20) of calculating the set frequency based on the plurality of reference impedances.

The high-speed battery defect inspection method of the present disclosure may obtain an optimal set frequency capable of accurately detecting low-voltage defective batteries, by performing the reference impedance measurement step (s10) and the set frequency calculation step (s20), prior to the analysis target impedance measurement step (s30).

In the reference impedance measurement step (s10), as a low-voltage defective battery, the reference battery may have a delta open circuit voltage (dOCV) of 300 mV or more or 3 sigma or more. The reference battery, which is a low-voltage defective battery, may be obtained as a battery that has been inspected as a defective battery in the mass production process or a battery subjected to defective conditions such as electrode folding and active material application area defect.

The reference impedance measurement step (s10) may be performed by impedance spectroscopy (EIS). Thus, a reference impedance value corresponding to each of the plurality of frequency values may be obtained.

As shown in FIG. 5, the set frequency calculation step (s20) may include a variable separation step (s21) of separating the plurality of reference impedances into real part values $Z_{SR}$ and imaginary part values $Z_{S1}$, a function fitting step (s22) of obtaining a function f to relate the $Z_{SR}$ to the $Z_{S1}$, and a set frequency acquisition step (s23) of obtaining the set frequency based on the function.

In the function fitting step (s22) of the high-speed battery defect inspection method of the present disclosure, the function f may be fitted by Formula 1 below.

[Formula 1]

$$Z_{SR} = f(Z_{SI})$$

In other words, in the function fitting step (s22), the function f may be obtained in the form of a function in which real part values $Z_{SR}$ are dependent variables and imaginary part values $Z_{SI}$ are independent variables.

In the set frequency acquisition step (s23), the set frequency may be selected from frequencies satisfying Formula 2 below for a section in which $Z_{SI}$ has a value greater than 0.

[Formula 2]

$$-\varepsilon \leq \frac{df(Z_{SI})}{dZ_{SI}} \leq \varepsilon$$

wherein ε is a real number of from 0.0 to 0.2. For example, ε may be determined in consideration of tolerances of specifications and capacities of reference batteries, materials and structures of electrode materials, and the like. For another example, ε may be determined in consideration of a deviation value of reference impedance values obtained for a plurality of reference batteries.

In the set frequency step, ε may be zero. In other words, a frequency when a value obtained by differentiating the function f by $Z_{SI}$ is 0 may be obtained as the set frequency. More specifically, a frequency value when the function f has a maximum value may be obtained as the set frequency.

In the defect determination step (s50), the analysis target battery may be determined as a defective battery when the real part resistance is at least 30% greater than a $Z_{SI}$ value satisfying the Formula 2. As described above for the low-voltage defective battery, the function f may have a maximum value with respect to the set frequency, and the real part resistance value may have an abnormally large value. According to the experimental example to be described later, it may be seen that at the set frequency, the real part resistance value of the low-voltage defective battery is more than twice as large as the real part resistance value of the normal defective battery. Therefore, when the real part resistance is at least 30% or more or 50% or more greater than the $Z_{SI}$ values that satisfy Formula 2 above, the analysis target battery may be determined as a low-voltage defective battery.

A battery activation method applying the high-speed battery defect inspection method of the present disclosure may include

an activation battery preparation step of preparing an activation target battery through an assembly process;
a charging/discharging step of charging or discharging the activation target battery;
a stabilization step of stabilizing the activation target battery by storing the activation target battery for a predetermined period of time at a set temperature and a set humidity; and
a defect screening step of finally screening defective batteries by performing the high-speed battery defect inspection method using the activation target battery as the analysis target battery.

The activation target battery prepared in the activation battery preparation step may be a battery that has completed a packaging process.

By applying the high-speed battery defect inspection method of the present disclosure to the battery activation process, the time required for battery defect inspection before shipment may be significantly reduced.

The battery activation method of the present disclosure may further include between the activation battery preparation step and the charging/discharging step, a pre-inspection step of pre-inspecting the activation target battery by performing the high-speed battery defect inspection method of the present disclosure using the activation target battery as the analysis target battery.

The battery activation method of the present disclosure may prevent the charging/discharging process and the aging process from being performed on the defective battery by primarily screening defective batteries before the charging/discharging process and the aging process, and defective batteries that may occur during the solid electrolyte interphase (SEI) layer formation process may be removed again by secondarily screening defective batteries after the aging process.

Experimental Examples

Fifteen batteries of 100 Ah with the activation process completed were prepared. Of these, five are normal batteries, five are grade E defective batteries, and five are grade L defective batteries.

EIS was performed on fifteen batteries, and the results shown in FIG. 3 were obtained.

In the five normal batteries, the real part resistance values at a frequency of 10 kHz corresponding to the set frequency were measured as 500 $\mu\Omega$, 480 $\mu\Omega$, 470 $\mu\Omega$, 490 $\mu\Omega$, and 520 $\mu\Omega$, respectively, in the five grade E defective batteries, the real part resistance values at a frequency of 10 kHz corresponding to the set frequency were measured as 1160 $\mu\Omega$, 1140 $\mu\Omega$, 1110 $\mu\Omega$, 1130 $\mu\Omega$ and 1110 $\mu\Omega$, respectively, and in the five grade L defective batteries, the real part resistance values at a frequency of 10 kHz corresponding to the set frequency were measured as 1120 $\mu\Omega$, 1070 $\mu\Omega$, 1150 $\mu\Omega$, 1140 $\mu\Omega$, and 1170 $\mu\Omega$, respectively.

In other words, it may be seen that in the low-voltage defective battery, a real part resistance value that is twice or more larger than that of the normal battery at the set frequency is measured.

Although embodiments according to the present disclosure have been described above, they are only illustrative and those skilled in the art will understand that various modifications and embodiments are possible therefrom. Therefore, the true technical protection scope of the present disclosure should be defined by the following claims.

Industrial Applicability

High-speed battery defect inspection methods of the present disclosure may detect low-voltage defective batteries in a short time, and may be capable of inspecting thousands to tens of thousands of batteries per second.

The high-speed battery defect inspection methods of the present disclosure is capable of performing non-destructive inspection on finished batteries, and may be applicable to batteries in mass production lines and batteries that have already been produced.

Compared to conventional methods, the high-speed battery defect inspection methods of the present disclosure significantly reduce inspection time, and may be capable of determining defects even in batteries that have not been inspected.

**Claims**

1. A high-speed battery defect inspection method, comprising:

   an analysis target impedance measurement step (s30) of obtaining an analysis target impedance which is an impedance of an analysis target battery measured by applying an alternating current at a set frequency to the analysis target battery;
   a real part resistance extraction step (s40) of extracting a real part value as a real part resistance from the analysis target impedance; and
   **characterised by**:

   a defect determination step (s50) of determining a low-voltage defect of the analysis target battery based on the real part resistance,
   wherein the set frequency is selected from frequencies in which an imaginary part value of the analysis target impedance is greater than 0.

2. The method of claim 1, wherein the set frequency is between $10^{-2}$ kHz and 7 MHz.

3. The method of claim 1, wherein the analysis target battery comprises a plurality of monocells.

4. The method of claim 1, further comprising:

   prior to the analysis target impedance measurement step (s30),
   a reference impedance measurement step (s10) of obtaining a plurality of reference impedances for a plurality of frequencies by applying an alternating current to a reference battery at varying frequencies; and
   a set frequency calculation step (s20) of calculating the set frequency based on the plurality of reference impedances.

5. The method of claim 4, wherein the reference battery has a dOCV of 300 mV or greater or three sigma or more.

6. The method of claim 4, wherein the set frequency calculation step (s20) comprises:

   a variable separation step (s21) of separating the plurality of reference impedances into real part values $Z_{SR}$ and imaginary part values $Z_{SI}$;
a function fitting step (s22) of fitting a function f to relate the $Z_{SR}$ to the $Z_{SI}$; and
a set frequency acquisition step (s23) of obtaining the set frequency based on the function.

7. The method of claim 6, wherein in the function fitting step (s22),
the function f is fitted by an equation of Formula 1 below:

[Formula 1]

$$Z_{SR} = f(Z_{SI})$$

8. The method of claim 7, wherein in the set frequency acquisition step (s23),

the set frequency is selected from frequencies satisfying an equation of Formula 2 below for a section in which the $Z_{SI}$ has a value greater than 0:

[Formula 2]

$$-\varepsilon \leq \frac{df(Z_{SI})}{dZ_{SI}} \leq \varepsilon$$

wherein $\varepsilon$ is between 0.0 and 0.2.

9. The method of claim 8, wherein in the set frequency acquisition step, $\varepsilon$ is 0.

10. The method of claim 9, wherein in the defect determination step (s50),
the analysis target battery is determined as a defective battery when the real part resistance is at least 30% greater than the $Z_{SI}$ value satisfying the equation of Formula 2.

11. A battery activation method comprising:

an activation battery preparation step of assembling an activation target battery;
a charging/discharging step of charging or discharging the activation target battery;
a stabilization step of stabilizing the activation target battery by storing the activation target battery for a predetermined period of time at a set temperature and a set humidity; and
a defect screening step of finally screening defective batteries by performing the high-speed battery defect inspection method of claim 1 using the activation target battery as the analysis target battery.

12. The method of claim 11, further comprising:

between the activation battery preparation step and the charging/discharging step,
a pre-inspection step of pre-inspecting the activation target battery by performing the high-speed battery defect inspection method of claim 1 using the activation target battery as the analysis target battery.

**Patentansprüche**

1. Hochgeschwindigkeits-Batteriedefektprüfverfahren, umfassend:

einen Analysezielimpedanz-Messschritt (s30) des Erhaltens einer Analysezielimpedanz, die eine Impedanz einer Analysezielbatterie ist, die durch Anlegen eines Wechselstroms mit einer eingestellten Frequenz an die Analysezielbatterie gemessen wird;
einen Realteilwiderstand-Extraktionsschritt (s40) des Extrahierens eines Realteilwerts als einen Realteilwiderstand aus der Analysezielimpedanz;
**gekennzeichnet durch**:

einen Defektbestimmungsschritt (s50) des Bestimmens eines Niederspannungsdefekts der Analysezielbatterie basierend auf dem Realteilwiderstand,
wobei die eingestellte Frequenz aus Frequenzen ausgewählt wird, bei denen ein Imaginärteilwert der Analysezielimpedanz größer als o ist.

2. Verfahren nach Anspruch 1, wobei die eingestellte Frequenz zwischen $10^{-2}$ kHz und 7 MHz liegt.

3. Verfahren nach Anspruch 1, wobei die Analysezielbatterie mehrere Monozellen umfasst.

4. Verfahren nach Anspruch 1, ferner umfassend:

vor dem Analysezielimpedanz-Messschritt (s30),
einen Referenzimpedanz-Messschritt (s10) des Erhaltens mehrerer Referenzimpedanzen für mehrere Frequenzen durch Anlegen eines Wechselstroms an eine Referenzbatterie mit variierenden Frequenzen; und
einen Einstellfrequenz-Berechnungsschritt (s20) des Berechnens der Einstellfrequenz basierend auf den mehreren Referenzimpedanzen.

5. Verfahren nach Anspruch 4, wobei die Referenzbatterie einen dOCV von 300 mV oder mehr oder drei Sigma oder mehr aufweist.

6. Verfahren nach Anspruch 4, wobei der Einstellfrequenz-Berechnungsschritt (s20) umfasst:

   einen variablen Trennungsschritt (s21) des Trennens der mehreren Referenzimpedanzen in Realteilwerte $Z_{SR}$ und Imaginärteilwerte $Z_{SI}$; einen Funktionsanpassungsschritt (s22) des Anpassens einer Funktion f, um das $Z_{SR}$ mit dem $Z_{SI}$ in Beziehung zu setzen; und einen Einstellfrequenz-Erfassungsschritt (s23) des Erhaltens der Einstellfrequenz basierend auf der Funktion.

7. Verfahren nach Anspruch 6, wobei in dem Funktionsanpassungsschritt (s22) die Funktion f durch eine Gleichung der nachstehenden Formel 1 angepasst wird:

   [Formel 1]

   $$Z_{SR} = f(Z_{SI})$$ .

8. Verfahren nach Anspruch 7, wobei in dem Einstellfrequenz-Erfassungsschritt (s23)

   die eingestellte Frequenz aus Frequenzen ausgewählt wird, die eine Gleichung der nachstehenden Formel 2 für einen Abschnitt erfüllen, in dem das $Z_{SI}$ einen Wert größer als 0 aufweist:

   [Formel 2]

   $$-\varepsilon \leq \frac{df(Z_{SI})}{dZ_{SI}} \leq \varepsilon$$ ,

   wobei $\varepsilon$ zwischen 0,0 und 0,2 liegt.

9. Verfahren nach Anspruch 8, wobei in dem Einstellfrequenz-Erfassungsschritt $\varepsilon$ 0 ist.

10. Verfahren nach Anspruch 9, wobei in dem Defektbestimmungsschritt (s50) die Analysezielbatterie als eine defekte Batterie bestimmt wird, wenn der Realteilwiderstand mindestens 30 % größer als der $Z_{SI}$-Wert ist, der die Gleichung der Formel 2 erfüllt.

11. Batterieaktivierungsverfahren, umfassend:

    einen Aktivierungsbatterie-Vorbereitungsschritt des Zusammenbauens einer Aktivierungszielbatterie; einen Lade-/Entladeschritt des Ladens oder Entladens der Aktivierungszielbatterie; einen Stabilisierungsschritt des Stabilisierens der Aktivierungszielbatterie durch Lagern der Aktivierungszielbatterie für eine vorbestimmte Zeitdauer bei einer eingestellten Temperatur und einer eingestellten Feuchtigkeit; und einen Defektprüfschritt des abschließenden Prüfens defekter Batterien durch Durchführen des Hochgeschwindigkeits-Batteriedefektprüfverfahrens nach Anspruch 1 unter Verwendung der Aktivierungszielbatterie als die Analysezielbatterie.

12. Verfahren nach Anspruch 11, ferner umfassend:

    zwischen dem Aktivierungsbatterie-Vorbereitungsschritt und dem Lade-/Entladeschritt, einen Vorprüfschritt des Vorprüfens der Aktivierungszielbatterie durch Durchführen des Hochgeschwindigkeits-Batteriedefektprüfverfahrens nach Anspruch 1 unter Verwendung der Aktivierungszielbatterie als die Analysezielbatterie.

**Revendications**

1. Procédé d'inspection de défaut de batterie à grande vitesse, comprenant :

   une étape de mesure d'impédance de cible d'analyse (s30) consistant à obtenir une impédance cible d'analyse qui est une impédance d'une batterie cible d'analyse mesurée en appliquant un courant alternatif à une fréquence définie à la batterie cible d'analyse ; une étape d'extraction de résistance de partie réelle (s40) consistant à extraire une valeur de partie réelle étant une résistance de partie réelle de l'impédance cible d'analyse ; et **caractérisé en ce que** :

   une étape de détermination de défaut (s50) consistant à déterminer un défaut de basse tension de la batterie cible d'analyse sur la base de la résistance de partie réelle, dans lequel la fréquence définie est sélectionnée parmi des fréquences dans lesquelles une valeur de partie imaginaire de l'impédance cible d'analyse est supérieure à 0.

2. Procédé selon la revendication 1, dans lequel la fréquence définie est comprise entre $10^{-2}$ kHz et 7 MHz.

3. Procédé selon la revendication 1, dans lequel la batterie cible d'analyse comprend une pluralité de monocellules.

**4.** Procédé selon la revendication 1, comprenant en outre :

avant l'étape de mesure d'impédance de cible d'analyse (s30),
une étape de mesure d'impédance de référence (s10) consistant à obtenir une pluralité d'impédances de référence pour une pluralité de fréquences en appliquant un courant alternatif à une batterie de référence à des fréquences variables ; et
une étape de calcul de fréquence définie (s20) consistant à calculer la fréquence définie sur la base de la pluralité d'impédances de référence.

**5.** Procédé selon la revendication 4, dans lequel la batterie de référence a un dOCV égal ou supérieur à 300 mV ou égal ou supérieur à trois sigma.

**6.** Procédé selon la revendication 4, dans lequel l'étape de calcul de fréquence définie (s20) comprend :

une étape de séparation variable (s21) consistant à séparer la pluralité d'impédances de référence en des valeurs de partie réelle $Z_{SR}$ et des valeurs de partie imaginaire $Z_{SI}$ ;
une étape d'ajustement de fonction (s22) consistant à ajuster une fonction f pour relier le $Z_{SR}$ au $Z_{SI}$ ; et
une étape d'acquisition de fréquence définie (s23) consistant à obtenir la fréquence définie sur la base de la fonction.

**7.** Procédé selon la revendication 6, dans lequel, à l'étape d'ajustement de fonction (s22),
la fonction f est ajustée par une équation de la Formule 1 ci-dessous :

[Formule 1]

$$Z_{SR} = f(Z_{SI})$$

.

**8.** Procédé selon la revendication 7, dans lequel, à l'étape d'acquisition de fréquence définie (s23), la fréquence définie est sélectionnée parmi des fréquences satisfaisant à une équation de la Formule 2 ci-dessous pour une section dans laquelle le $Z_{SI}$ a une valeur supérieure à 0 :

[Formule 2]

$$-\varepsilon \leq \frac{df(Z_{SI})}{dZ_{SI}} \leq \varepsilon$$

,

où $\varepsilon$ est compris entre 0,0 et 0,2.

**9.** Procédé selon la revendication 8, dans lequel, à l'étape d'acquisition de fréquence définie, $\varepsilon$ est 0,

**10.** Procédé selon la revendication 9, dans lequel, à l'étape de détermination de défaut (s50),
la batterie cible d'analyse est déterminée être une batterie défectueuse quand la résistance de partie réelle est au moins 30 % supérieure à la valeur $Z_{SI}$ satisfaisant à l'équation de la Formule 2.

**11.** Procédé d'activation de batterie comprenant :

une étape de préparation d'activation de batterie consistant à assembler une batterie cible d'activation ;
une étape de charge/décharge consistant à charger ou décharger la batterie cible d'activation ;
une étape de stabilisation consistant à stabiliser la batterie cible d'activation en stockant la batterie cible d'activation pendant une période de temps prédéterminée à une température définie et une humidité définie ; et
une étape de dépistage de défaut consistant à dépister finalement des batteries défectueuses en effectuant le procédé d'inspection de défaut de batterie à grande vitesse selon la revendication 1 en utilisant la batterie cible d'activation comme batterie cible d'analyse.

**12.** Procédé selon la revendication 11, comprenant en outre :

entre l'étape de préparation de batterie d'activation et l'étape de charge/décharge,
une étape de pré-inspection consistant à pré-inspecter la batterie cible d'activation en effectuant le procédé d'inspection de défaut de batterie à grande vitesse selon la revendication 1 en utilisant la batterie cible d'activation comme batterie cible d'analyse.

[FIG. 1]

```
┌─────────────────────────────────┐
│    Analysis target impedance    │ ⟞∿∿∿  s30
│       measurement step          │
└─────────────────────────────────┘
                │
                ▼
┌─────────────────────────────────┐
│  Real part resistance extraction │ ⟞∿∿∿  s40
│             step                │
└─────────────────────────────────┘
                │
                ▼
┌─────────────────────────────────┐
│    Defect determination step    │ ⟞∿∿∿  s50
└─────────────────────────────────┘
```

[FIG. 2]

Imaginary part(-)

Low frequency(mHz)

High frequency(kHz)          Real part(+)

[FIG. 3]

[FIG. 4]

```
┌─────────────────────────────────┐
│      Reference impedance         │ ⟩ s10
│      measurement step            │
└─────────────────────────────────┘
              │
              ▼
┌─────────────────────────────────┐
│   Set frequency calculation step │ ⟩ s20
└─────────────────────────────────┘
              │
              ▼
┌─────────────────────────────────┐
│    Analysis target impedance     │ ⟩ s30
│      measurement step            │
└─────────────────────────────────┘
              │
              ▼
┌─────────────────────────────────┐
│  Real part resistance extraction │ ⟩ s40
│              step                │
└─────────────────────────────────┘
              │
              ▼
┌─────────────────────────────────┐
│     Defect determination step    │ ⟩ s50
└─────────────────────────────────┘
```

[FIG. 5]

```
┌─────────────────────────────────┐
│     Variable separation step     │ ⟩ s21
└─────────────────────────────────┘
              │
              ▼
┌─────────────────────────────────┐
│      Function fitting step       │ ⟩ s22
└─────────────────────────────────┘
              │
              ▼
┌─────────────────────────────────┐
│   Set frequency acquisition step │ ⟩ s23
└─────────────────────────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220140870
- US 11264599 B2